(19) Europäisches Patentamt
European Patent Office
Office européen des brevets

(11) **EP 2 731 721 B1**

(12) **EUROPÄISCHE PATENTSCHRIFT**

(45) Veröffentlichungstag und Bekanntmachung des Hinweises auf die Patenterteilung:
**08.04.2020   Patentblatt 2020/15**

(21) Anmeldenummer: **12724113.1**

(22) Anmeldetag: **22.05.2012**

(51) Int Cl.:
**B01L 3/00** (2006.01)   **F16K 99/00** (2006.01)

(86) Internationale Anmeldenummer:
**PCT/EP2012/059417**

(87) Internationale Veröffentlichungsnummer:
**WO 2013/007433 (17.01.2013 Gazette 2013/03)**

(54) **MIKROFLUIDISCHE VORRICHTUNG SOWIE VERFAHREN ZUR HERSTELLUNG EINER MIKROFLUIDISCHEN VORRICHTUNG**

MICROFLUIDIC DEVICE AND METHOD FOR PRODUCING A MICROFLUIDIC DEVICE

DISPOSITIF MICROFLUIDIQUE ET PROCÉDÉ DE PRODUCTION D'UN DISPOSITIF MICROFLUIDIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **11.07.2011   DE 102011078976**

(43) Veröffentlichungstag der Anmeldung:
**21.05.2014   Patentblatt 2014/21**

(73) Patentinhaber: **Robert Bosch GmbH**
**70442 Stuttgart (DE)**

(72) Erfinder:
• **BRETTSCHNEIDER, Thomas**
**70806 Kornwestheim (DE)**
• **DORRER, Christian**
**70193 Stuttgart (DE)**

(56) Entgegenhaltungen:
**EP-A1- 2 025 405        WO-A2-02/41994**
**US-A1- 2006 076 068        US-A1- 2010 303 687**

EP 2 731 721 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

Printed by Jouve, 75001 PARIS (FR)

**Beschreibung**

Stand der Technik

Die Erfindung betrifft eine mikrofluidische Vorrichtung, ein Verfahren zur Herstellung einer mikrofluidischen Vorrichtung sowie eine Verwendung einer mikrofluidischen Vorrichtung.

Mikrofluidische Vorrichtungen kommen beispielsweise als Lab-on-a-Chip-Systeme im Rahmen molekulardiagnostischer Laboranwendungen zu Einsatz. Die Verwendung von derartigen mikrofluidischen Vorrichtungen ermöglicht nicht nur eine Diagnose in einem Großlabor oder einer Arztpraxis, sondern ein Patient kann beispielsweise auch mit Hilfe der mikrofluidischen Vorrichtung entsprechende Überprüfungen, beispielsweise von Markern oder des Blutzuckerspiegels, zu Hause selbst durchführen.

Derartige mikrofluidische Vorrichtungen werden beispielsweise aus Polymerplatten mit integrierten Kanälen und/oder Kavitäten hergestellt, um Flüssigkeiten und dergleichen zu transportieren und/oder zu filtern. Um die mikrofluidische Vorrichtung mit Flüssigkeiten oder Druckluft beaufschlagen zu können, kann diese über Schläuche mit einer fluidbereitstellenden Einrichtung verbunden werden. Über die Schläuche kann die fluidbereitstellende Einrichtung gezielt die Kanäle und/oder die Kavitäten mit Druck beaufschlagen und damit Flüssigkeiten bewegen. Darüber hinaus ist auch eine pneumatische Steuerung von mikrofluidischen Pumpen und/oder Ventilen möglich. Um gezielt Einzelfunktionen der mikrofluidischen Vorrichtung ausführen zu können, werden unterschiedliche Drücke oder Druckniveaus benötigt. Diese werden von einer pneumatischen Einrichtung außerhalb der mikrofluidischen Vorrichtung erzeugt und über zusätzliche Anschlüsse der mikrofluidischen Vorrichtung bereitgestellt.

Aus der WO 2007109375 A2 ist ein mikrofluidisches Sperrventil für eine mikrofluidische Vorrichtung bekannt geworden. Das mikrofluidische Sperrventil umfasst dabei einen Einlass, zumindest drei Membranventile, umfassend Ventileinlässe, Ventilauslässe, Ventilsteuerungen und Elastomer-Membranen. Bei Beaufschlagung einer Ventilsteuerung mit einem Druck oder einem Vakuum wird die Elastomer-Membran ausgelenkt, um einen Fluss einer Flüssigkeit zu modulieren. Zwei der Ventile sind mit einem dritten Ventil derart verbunden, sodass ein ausreichend großes Vakuum an einem Einlass des mikrofluidischen Sperrventils dazu führt, dass das dritte Ventil geöffnet ist und dass ein ausreichender Druck an dem Einlass des mikrofluidischen Sperrventils bereitgestellt wird, sodass das dritte Ventil geschlossen wird.

Aus der US 200770166199 A1 ist ein mikrofluidisches System umfassend einen pneumatischen Mehrfachverteiler mit Öffnungen und einen Chip-Verteiler mit Kanälen bekannt geworden, um pneumatisch Signale von den entsprechenden Öffnungen zu druckbetätigbaren Membranen in einem mikrofluidischen Chip zu senden. Die Kanäle transportieren dabei die pneumatischen Signale entsprechend einer festgelegten Konfiguration der druckbetätigbaren Membranen in dem mikrofluidischen Chip. Der mikrofluidische Chip umfasst ebenfalls Reagenzreservoire, um fluidische Reagenzien zu speichern und Ausgangsspeicher zum Speichern von Reaktionsprodukten der fluidischen Reagenzien.

WO 02/41994 A2 offenbart eine Assay-Vorrichtung, in der ein flüssigphasiges chemisches Assay durchgeführt wird, mit einer Probenkammer zur Aufnahme einer flüssigen Probe und wenigstens eine Fluid-Steuereinrichtung zum Steuern der Bewegung von Flüssigkeit in und/oder aus die Probenkammer, wobei die Fluid Steuereinrichtung eine Auslasskammer des Fluids in fluidischer Kommunikation mit der Probenkammer, und eine verschiebbare flexible Membran aufweist, wobei durch deren Verschiebung sich das Volumen der Auslasskammer so verändert, um damit einen Fluidstrom Fluidströmung zwischen dem Auslass und Probekammern zu ermöglichen und/oder einzuschränken.

US 2010/303687 A1 zeigt mikrofluidische Fluidikvorrichtungen mit Membranventilen mit niedrigen Ausfallraten. Hierzu werden freiliegende Oberflächen, welche der Membran zugewandt sind, mit einem Material niedriger Energie, wie ein Edelmetall, ein perfluoriertes Polymer, eine selbstorganisierte Monoschicht, hartem Diamant, diamantartigem Kohlenstoff oder einem Metalloxid versehen. Zudem können die Ventile mit Rippen versehen sein und die Membran ist mit der fluidischen oder Betätigungsschicht mit einem Klebstoff verklebt.

US 2006/076068 A1 offenbart mikrofluidische Kunststoffstrukturen mit einer im Wesentlichen starren Membran, welche zwischen einem entspannten Zustand, in dem die Membran gegen die Oberfläche eines Substrats sitzt, und einem aktivierten Zustand betätigt, in dem die Membran von dem Substrat weg bewegt wird.

EP 2 025 405 A1 offenbart eine Dosiervorrichtung, welche einen Fluidik-Chip und eine Dosierkammer aufweist. Wählbare Auslassventile stehen mit jeder Dosierkammer in Wirkverbindung, um ein diskret dosiertes Volumen bereitzustellen. Die Ventile können gemeinsam gesteuert werden und als mehrstufige Ventile gebildet werden. Druckanschlüsse werden eingesetzt, um die Ventile zu betätigen. Die Vorrichtung umfasst eine flexible Membran und eine Basis. Ein Substrat mit Fluidöffnungen wirkt mit der Membran zusammen. Die Vorrichtung weist eine Lippe auf, welche die Membran umgibt.

Offenbarung der Erfindung

In Anspruch 1 ist eine erfindungsgemäße mikrofluidische Vorrichtung definiert.

In Anspruch 4 ist ein Verfahren zur Herstellung einer mikrofluidischen Vorrichtung gemäß zumindest einem der Ansprüche 1 bis 3 definiert, wobei zumindest die Kavität und/oder der Kanal mittels Fräsen, Spritzguss und/oder Heißprägen hergestellt wird.

In Anspruch 6 ist eine Verwendung einer mikrofluidischen Vorrichtung gemäß zumindest einem der Ansprüche 1 bis 3 als Lab-on-a-Chip-System definiert.

Zu Anspruch 7 ist ein mikrofluidisches System mit einer Mehrzahl von mikrofluidischen Vorrichtungen gemäß zumindest einem der Ansprüche 1 - 3 definiert.

Vorteile der Erfindung

Durch die vorgegebenen Verdrängungsvolumina können auf einfache Weise unterschiedliche Druckniveaus von Kavitäten innerhalb eines mikrofluidischen Systems mit mehreren mikrofluidischen Vorrichtungen zur Verfügung gestellt werden, wobei lediglich ein einzelnes Druckniveau von außen für das mikrofluidische System bzw. die mikrofluidischen Vorrichtungen zur Verfügung gestellt werden muss.

Die zugrunde liegende Idee der vorliegenden Erfindung besteht also darin, dass zur Begrenzung der Druckveränderung in der Kavität trotz eines durch einen von außen bereitgestellten höheren oder niedrigeren Druckes bzw. trotz Beaufschlagung der Membran mit diesem Druck sich zwar die Membran ausdehnt und so den Druck in der Kavität verändert, nicht jedoch über einen vorbestimmten Wert hinaus. Durch die Ausdehnung der Membran verringert sich das Gesamtvolumen der Kavität, wodurch der Druck in der Kavität ansteigt. Der bei Erreichen der maximalen Ausdehnung der Membran erreichte Druck in der Kavität ist dabei unabhängig von dem äußeren bereitgestellten Druck, solange das Druckniveau des äußeren Druckes groß genug ist, um die Membran vollständig in ein vorgegebenes Verdrängungsvolumen auszulenken. Der Druck in der Kavität bei vollständiger Ausdehnung der Membran ist auch dann konstant, wenn der außen angelegte Druck oberhalb des minimalen Drucks für eine vollständige Ausdehnung der Membran schwankt, beispielsweise aufgrund eines instabilen externen Druckerzeugers. Auf diese Weise wird einerseits die Zuverlässigkeit der Bereitstellung des Druckes durch die Membran in der Kavität erhöht, andererseits sind damit auch günstigere Druckerzeuger zur Bereitstellung des äußeren Druckes für die mikrofluidische Vorrichtung möglich.

Ebenso bietet die Erfindung den Vorteil, dass für ein mikrofluidisches System auf einen externen Druckerzeuger zur Bereitstellung von unterschiedlichen Drücken verzichtet werden kann, da reduzierte Drücke innerhalb des mikrofluidischen Systems mittels der Membran, Kavität und Begrenzungsmittel erzeugt werden können. Dadurch ist eine äußerst kostengünstige Steuerung des mikrofluidischen Systems und der mikrofluidischen Vorrichtung möglich. Auch kann die fluidbereitstellende Einrichtung wesentlich kompakter ausgeführt werden: Ist eine sehr genaue Vorgabe eines bestimmten Druckes in einem mikrofluidischen System notwendig, sind üblicherweise aufwendige und damit kostenintensive, externe Druckerzeuger nötig, um diesen genauen Druck bereitstellen zu können. Aufgrund des Begrenzungsmittels lässt sich ein gewünschter Druck in der Kavität insbesondere über eine vorgegebene Größe des Verdrängungsvolumens der Membran äußerst genau vorgeben.

Darüber hinaus bietet die Erfindung auch den Vorteil, dass auch sehr geringe Überdrücke einfach und zuverlässig möglich sind. Durch eine Ausbildung des Begrenzungsmittels, insbesondere indem das Begrenzungsmittel ein entsprechend kleines Verdrängungsvolumen für die Membran zur Verfügung stellt, sind auch kleinste Überdrücke einfach und zuverlässig bereitstellbar. Schließlich bietet die Erfindung auch den Vorteil, dass die Anzahl von Schnittstellen zwischen externen Druckerzeugern und dem mikrofluidischen System verringert werden kann. Es führt nicht nur zu einer Reduzierung der Herstellungskosten, sondern auch zu einer geringeren Fehleranfälligkeit und zu geringeren Wartungskosten.

Weitere vorteilhafte Ausführungsformen und Merkmale der Erfindung sind in den Unteransprüchen beschrieben.

Gemäß einer vorteilhaften Weiterbildung der Erfindung umfasst die Aussparung abgerundete Kanten. Auf diese Weise wird sichergestellt, dass die elastische Membran zum einen das gesamte Verdrängungsvolumen, definiert durch die Begrenzungsmittel, verdrängen kann, gleichzeitig wird die Gefahr einer Beschädigung der Membran bei deren wiederholter Betätigung entsprechend reduziert.

Gemäß einer weiteren vorteilhaften Weiterbildung der Erfindung ist zumindest eine der Schichten aus einem Polymer, insbesondere einem Thermoplast hergestellt und/oder die Membran aus einem thermoplastischen Elastomer und/oder einem Thermoplasten hergestellt. Der damit erzielte Vorteil ist, dass damit eine einfache und kostengünstige Herstellung der mikrofluidischen Vorrichtung und eine ausreichende Langlebigkeit der Membran bei gleichzeitig kostengünstiger Herstellung ermöglicht wird. Als Polymer können insbesondere Thermoplaste, beispielsweise PC, PT, PE, PMMA, COP, COC und dergleichen zum Einsatz kommen.

Gemäß einer weiteren vorteilhaften Weiterbildung des Verfahrens zur Herstellung einer mikrofluidischen Vorrichtung gemäß Anspruch 4 werden die zumindest zwei Schichten mittels Laserdurchstrahlschweißen, Ultraschallschweißen und/oder mittels eines Klebeverfahrens fest miteinander verbunden. Das Fügen des Schichtaufbaus der mikrofluidischen Vorrichtung kann auf diese Weise zuverlässig und kostengünstig erfolgen.

Kurze Beschreibung der Zeichnungen

Weitere Merkmale und Vorteile der Erfindung ergeben sich aus der nachfolgenden Beschreibung von Ausführungsbeispielen anhand der Zeichnungen. Dabei zeigt in schematischer Form

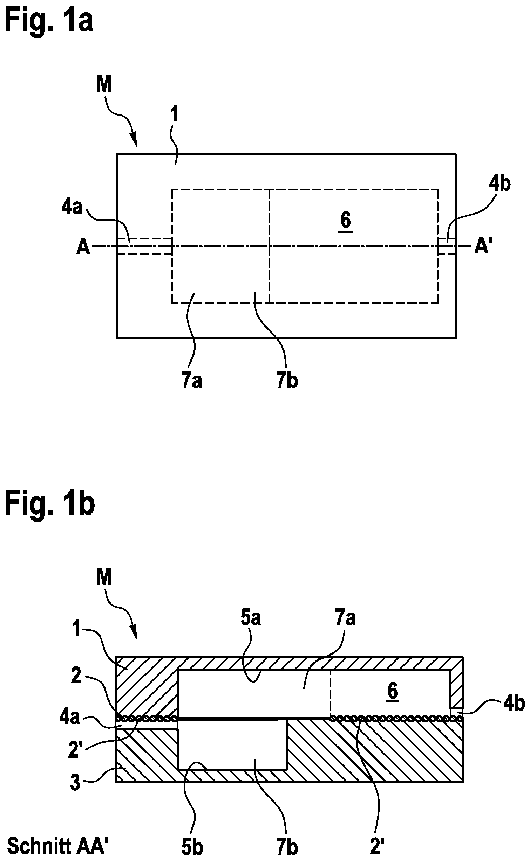

Fig. 1a eine mikrofluidische Vorrichtung gemäß einer Ausführungsform der vorliegenden Erfindung in der Draufsicht und

Fig. 1 b die mikrofluidische Vorrichtung gemäß der Ausführungsform im Querschnitt.

Ausführungsformen der Erfindung

Fig. 1 zeigt eine mikrofluidische Vorrichtung gemäß einer Ausführungsform in der Draufsicht und im Querschnitt.

In den Figuren 1a, 1b bezeichnet Bezugszeichen M eine mikrofluidische Vorrichtung. Die mikrofluidische Vorrichtung M umfasst dabei als eine erste Schicht eine oberste Schicht gemäß Figuren 1a, 1b eine obere Polymerschicht 1 und als eine zweite Schicht eine untere Polymerschicht 3 (nicht gezeigt in Fig. 1a). Elemente in der unteren Polymerschicht 3 sind in Fig. 1a gestrichelt angedeutet. In der unteren Polymerschicht 3 ist ein Kanal 4a angeordnet, der mit einem unteren Verdrängungsvolumen 7b, ausgebildet ebenfalls in der unteren Polymerschicht 3 pneumatisch in Verbindung steht. Das untere Verdrängungsvolumen 7b steht weiter mit einer Membran 2 in pneumatischer Verbindung, die zwischen den beiden Polymerschichten 1, 3 angeordnet ist. Die Membran 2 kann sich dabei im Wesentlichen vollständig in das untere Verdrängungsvolumen 7b ausdehnen. Weiter ist in der oberen Polymerschicht 1 eine Kavität 6 angeordnet, die mit einem oberen Verdrängungsvolumen 7a pneumatisch verbunden ist. Das obere Verdrängungsvolumen 7a ist dabei als Aussparung 5a in der oberen Polymerschicht 1 ausgebildet. Die Membran 2 ist dabei so zwischen den beiden Polymerschichten 1, 3 angeordnet, dass sich die Membran 2 je nach Druckbeaufschlagung des Kanals 4a in das obere Verdrängungsvolumen 7a oder in das untere Verdrängungsvolumen 7b ausdehnen kann. Dehnt sich die Membran 2 in das untere Verdrängungsvolumen 7b, angeordnet in der unteren Polymerschicht 3 aus, so wird der Druck in der Kavität 6 vermindert. Dehnt sich die Membran 2 in das obere Verdrängungsvolumen 7a der oberen Polymerschicht 3 aus, wird der Druck in der Kavität 6 erhöht.

Die Membran 2 gemäß Fig. 1a und 1b ist über eine Schweißnaht oder Klebeverbindung 2' mit der unteren Polymerschicht 1 und der oberen Polymerschicht 3 verbunden. Dabei ist die Schweißnaht oder Klebeverbindung 2' im Bereich des Kanals 4a an der oberen Polymerschicht 1 und im Bereich der Kavität 6 an der unteren Polymerschicht 3 angeordnet. Das obere Verdrängungsvolumen 7a wird dabei zum einen durch die Aussparung 5a bestimmt, zum anderen auch durch die Erstreckung der Schweißnaht oder Klebeverbindung 2' an der unteren Polymerschicht 3. Die Kavität 6 wird somit durch den Teil der Aussparung 5a gemäß Fig. 1b gebildet, in die sich die Membran 2 auf Grund der Festlegung an der unteren Polymerschicht 3 nicht ausdehnen kann. In das untere Verdrängungsvolumen 7b, gebildet durch die Aussparung 5b, kann sich die Membran 2 durch Unterdruckausbildung in dem Kanal 4a vollständig ausdehnen. An die Kavität 6 ist ein weiterer Kanal 4b, ausgebildet in der oberen Polymerschicht 3, angeordnet, der zum Anschluss an pneumatisch betätigbare Bauelemente, wie mikrofluidische Pumpen, Ventile, Filter, Reservoire, Kammern, Mischer und dergleichen, dient.

Allgemein wird ein Druck in dem Kanal 4a bereitgestellt, durch den sich dann die elastisch ausgebildete Membran 2 in das obere oder untere Verdrängungsvolumen 7a, 7b ausdehnen kann. Für den Druck in der Kavität 6 gemäß dem Boyle-Mariotteschen Gesetz gilt dann:

$$p_2 = \left( \frac{V_V + V_K + V_R}{V_K + V_R} \right) p_1$$

wobei $p_2$ den Druck nach einer Betätigung der Membran 2, $p_1$ einen Normaldruck, also einen Druck, bei dem die Membran 2 nicht gedehnt und/oder gestaucht wird, $V_v$ das Verdrängungsvolumen 7a, 7b, $V_K$ das Volumen der Kavität 6 und $V_R$ alle restlichen Volumina beschreibt, die mit der Kavität 6 verbunden sind, beispielsweise Kanäle 4b oder dergleichen. Allgemein können mit der Kavität 6 über den Kanal 4b, der mit der Kavität 6 pneumatisch verbunden ist, weitere pneumatisch betätigbare Elemente verbunden werden. Über eine Druckbeaufschlagung des Kanals 4a und damit der elastischen Membran 2 und deren Ausdehnung erfolgt eine entsprechende Druckerhöhung in der Kavität 6 und es wird eine Aktuierung der pneumatisch betätigbaren Elemente ermöglicht, die ein entsprechend angepasstes Druckniveau benötigen, beispielsweise eine Verdrängungskammer einer Membranpumpe oder Membranventile.

Ebenso ist es möglich ein an die Kavität angeschlossenes Kanalnetzwerk zu betätigen, indem ein definiertes Volumen innerhalb des Kanalnetzwerks, welches von der Kavität 6 durch ein Ventil getrennt sein kann, verdrängt wird. Auf diese Weise kann die Kavität 6 analog zu einem elektrischen Kondensator "aufgeladen" werden und nach Öffnung des Ventils das Kanalnetzwerk mit einem definierten Flüssigkeitsvolumen beaufschlagen. Wird beispielsweise ein pneumatischer Widerstand eines derartigen Kanalnetzwerks als R und die pneumatische Kapazität der Kavität als C definiert, so lässt sich der zeitliche Druckverlauf des Druckes innerhalb der Kavität näherungsweise beschreiben durch die Formel

$$p_2(t) = p_2(t=0)e^{-t/\tau}$$

mit der charakteristischen Zeitkonstante $\tau$ = RC. Aufgrund der starken Abhängigkeit des oben definierten pneumatischen Widerstandes R beispielsweise von einem Radius des entsprechenden Kanals, welcher gemäß dem Hagen-Poiseuille proportional zu $1/r^4$ ist, lässt

sich die charakteristische Zeitkonstante τ über einen weiten Bereich vorgeben, bzw. anpassen. So sind beispielsweise für Luft und typische Kanaldurchmesser zwischen 30 μm bis 500 μm Werte für die charakteristische Zeitkonstante von einer Sekunde bis $10^5$ Sekunden möglich.

Die Dicke einer Polymerschicht einer mikrofluidischen Vorrichtung kann dabei zwischen 0,1 mm bis 5 mm, insbesondere 0,5 mm bis 3 mm betragen. Die Dicke einer elastischen Membran kann dabei eine Dicke zwischen 10 μm und 500 μm, insbesondere 25 bis 300 μm aufweisen. Das Volumen einer Kavität einer mikrofluidischen Vorrichtung kann dabei zwischen 1 mm$^3$ bis 10.000 mm$^3$, insbesondere zwischen 10 mm$^3$ und 1.000 mm$^3$ betragen und/oder die Abmessungen der Kavität können dabei für die Länge und/oder Breite der Kavität zwischen 10 μm und 50mm, insbesondere zwischen 25 μm und 25 mm betragen und die Höhe der Kavität kann dabei zwischen 25 μm und 10 mm, insbesondere 50 μm und 5mm betragen. Das Verdrängungsvolumen 7a, 7b, definiert durch die Begrenzungsmittel 5a, 5b kann dabei in Abhängigkeit der gewünschten Druckänderung zwischen 0,1 mm$^3$ bis 5.000 mm$^3$, insbesondere zwischen 1 mm$^3$ und 2.000 mm$^3$ betragen.

Eine mikrofluidische Vorrichtung M insbesondere gemäß den Figuren 1a und 1b kann dabei laterale Abmessungen zwischen 1 mm$^2$ und $10^6$ mm$^2$, insbesondere zwischen 100 mm$^2$ und $10^4$ mm$^2$ aufweisen.

## Patentansprüche

1. Mikrofluidische Vorrichtung (M), umfassend zumindest zwei übereinander angeordnete Schichten (1, 3), nämlich einer ersten Schicht (1) und einer zweiten Schicht (3),
eine elastische Membran (2), welche zwischen den beiden Schichten (1, 3) angeordnet ist, eine Kavität (6), die in einer Aussparung (5a) der ersten Schicht (1) (1) angeordnet ist und mit einem in der Aussparung (5a) der ersten Schicht (1) ausgebildeten ersten Verdrängungsvolumen (7a) pneumatisch verbunden ist, und zumindest einen Kanal (4a) in der zweiten Schicht (3) zum Beaufschlagen der Membran (2) mit Druck, wobei der Kanal (4a) mit einem in der zweiten Schicht (3) ausgebildetem zweiten Verdrängungsvolumen (7b) pneumatisch in Verbindung steht, wobei das zweite Verdrängungsvolumen (7b) mit der Membran (2) in pneumatischer Verbindung steht, so dass die Membran (2) sich je nach Druckbeaufschlagung des Kanals (4a) in das erste Verdrängungsvolumen (7a) oder in das zweite Verdrängungsvolumen (7b) für eine Erhöhung beziehungsweise eine Verminderung eines Drucks in der Kavität (6) ausdehnen kann, **dadurch gekennzeichnet, dass** die Membran (2) zur Begrenzung der Druckveränderung in der Kavität (6) über eine Schweißnaht oder Klebeverbindung (2') im Bereich des Kanals (4a) mit der ersten Schicht (1) und im Bereich der Kavität (6) mit der zweiten Schicht (3) verbunden ist, so dass das erste Verdrängungsvolumen (7a) durch die Aussparung (5a) und durch die Erstreckung der Schweißnaht oder Klebeverbindung (2') an der zweiten Schicht (3) bestimmt wird und die Kavität (6) durch den Teil der Aussparung (5a) gebildet wird, in den sich die Membran (2) auf Grund der Schweißnaht oder der Klebeverbindung (2') mit der zweiten Schicht (3) nicht ausdehnen kann.

2. Mikrofluidische Vorrichtung gemäß Anspruch 1, wobei die Aussparung (5a, 5b) abgerundete Kanten umfasst.

3. Mikrofluidische Vorrichtung gemäß zumindest einem der Ansprüche 1 oder 2, wobei zumindest eine der Schichten (1, 3, 9) aus einem Polymer, insbesondere einem Thermoplast hergestellt ist und/oder die Membran (2) aus einem thermoplastischen Elastomer und/oder einem Thermoplast hergestellt ist.

4. Verfahren zur Herstellung einer mikrofluidischen Vorrichtung (M) gemäß einem der Ansprüche 1 - 3, wobei zumindest die Kavität (6) und/oder der Kanal (4, 10) mittels Fräsen, Spitzguss und/oder Heißprägen hergestellt wird.

5. Verfahren zur Herstellung einer mikrofluidischen Vorrichtung gemäß Anspruch 4, wobei die zumindest zwei Schichten (1, 3) mittels Laserdurchstrahlschweißen, Ultraschallschweißen und/oder mittels eines Klebverfahrens fest miteinander verbunden werden.

6. Verwendung einer mikrofluidischen Vorrichtung (M) gemäß einem der Ansprüche 1 - 3 als Lab-on-a-Chip-System.

7. Mikrofluidisches System mit einer Mehrzahl von mikrofluidischen Vorrichtungen gemäß einem der Ansprüche 1 - 3.

## Claims

1. Microfluidic device (M), comprising at least two layers (1, 3) arranged one above the other, namely a first layer (1) and a second layer (3); an elastic diaphragm (2) which is arranged between the two layers (1, 3); a cavity (6) which is arranged in a clearance (5a) of the first layer (1) (1) and is pneumatically connected to a first displacement volume (7a) formed in the clearance (5a) of the first layer (1); and at least one duct (4a) in the second layer (3) for applying pressure to the diaphragm (2), wherein the duct (4a) is pneumatically connected to a second displacement volume (7b) formed in the second layer (3), wherein the second displacement volume (7b) is pneumatically connected to the diaphragm (2) such that, depending on the application of pressure by the duct (4a) into the first displacement volume (7a) or into the second displacement volume (7b), the diaphragm can expand to increase or decrease a pressure in the cavity (6), **characterized in that**, to limit the pressure variation in the cavity (6), the diaphragm (2) is connected, via a weld seam or adhesive bond (2'), to the first layer (1) in the region of the duct (4a) and to the second layer (3) in the region of the cavity (6), with the result that the first displacement volume (7a) is determined by the clearance (5a) and by the extent of the weld seam or adhesive bond (2') on the second layer (3) and the cavity (6) is formed by that part of the clearance (5a) in which the diaphragm (2) cannot expand as a result of the weld seam or the adhesive bond (2') with the second layer (3).

2. Microfluidic device according to Claim 1, wherein the clearance (5a, 5b) comprises rounded edges.

3. Microfluidic device according to at least one of Claims 1 and 2, wherein at least one of the layers (1, 3, 9) is produced from a polymer, in particular a thermoplastic, and/or the diaphragm (2) is produced from a thermoplastic elastomer and/or a thermoplastic.

4. Method for producing a microfluidic device (M) according to one of Claims 1 - 3, wherein at least the cavity (6) and/or the duct (4, 10) are/is produced by means of milling, injection-moulding and/or hot-pressing.

5. Method for producing a microfluidic device according to Claim 4, wherein the at least two layers (1, 3) are firmly connected to one another by means of laser irradiation welding, ultrasonic welding and/or by means of an adhesive bonding method.

6. Use of a microfluidic device (M) according to one of Claims 1 - 3 as a lab-on-a-chip system.

7. Microfluidic system having a plurality of microfluidic devices according to one of Claims 1 - 3.

**Revendications**

1. Dispositif microfluidique (M), comportant au moins deux couches superposées (1, 3), à savoir une première couche (1) et une deuxième couche (3), une membrane élastique (2), laquelle est disposée entre les deux couches (1, 3), une cavité (6) qui est disposée dans un évidement (5a) de la première couche (1) (1) et reliée pneumatiquement à un premier volume de refoulement (7a) formé dans l'évidement (5a) de la première couche (1), et au moins un canal (4a) dans la deuxième couche (3) pour solliciter la membrane (2) en pression, le canal (4a) étant en liaison pneumatique avec un deuxième volume de refoulement (7b) formé dans la deuxième couche (3), le deuxième volume de refoulement (7b) étant en liaison pneumatique avec la membrane (2), de sorte que la membrane (2) peut se dilater, en fonction de la sollicitation en pression du canal (4a), dans le premier volume de refoulement (7a) ou dans le deuxième volume de refoulement (7b) pour une augmentation ou une réduction d'une pression dans la cavité (6), **caractérisé en ce que** la membrane (2) est, pour limiter la variation de pression dans la cavité (6), reliée à la première couche (1) dans la région du canal (4a) et à la deuxième couche (3) dans la région de la cavité (6), par le biais d'un joint de soudure ou d'une liaison adhésive (2'), de sorte que le premier volume de refoulement (7a) est déterminé par l'évidement (5a) et par l'étendue du joint de soudure ou de la liaison adhésive (2') sur la deuxième couche (3) et la cavité (6) est formée par la partie de l'évidement (5a) dans laquelle la membrane (2) ne peut pas se dilater en raison du joint de soudure ou de la liaison adhésive (2') à la deuxième couche (3).

2. Dispositif microfluidique selon la revendication 1, dans lequel l'évidement (5a, 5b) comporte des bords arrondis.

3. Dispositif microfluidique selon au moins l'une des revendications 1 et 2, dans lequel au moins l'une des couches (1, 3, 9) est produite à partir d'un polymère, en particulier à partir d'un thermoplastique, et/ou la membrane (2) est produite à partir d'un élastomère thermoplastique et/ou d'un thermoplastique.

4. Procédé de production d'un dispositif microfluidique (M) selon l'une des revendications 1 à 3, dans lequel au moins la cavité (6) et/ou le canal (4, 10) sont produits par fraisage, moulage par injection et/ou estampage à chaud.

5. Procédé de production d'un dispositif microfluidique selon la revendication 4, dans lequel lesdites au moins deux couches (1, 3) sont reliées solidement les unes aux autres par soudage laser par transparence, soudage par ultrasons et/ou par un procédé de collage.

6. Utilisation d'un dispositif microfluidique (M) selon l'une des revendications 1 à 3 en tant que système de laboratoire sur puce (« lab-on-a-chip »).

7. Système microfluidique comprenant une pluralité de dispositifs microfluidiques selon l'une des revendi-

cations 1 à 3.

## Fig. 1a

M

1

4a

4b

6

A — — — A'

7a    7b

## Fig. 1b

M

1

2

5a    7a

6

4b

4a

2'

3

5b    7b    2'

Schnitt AA'

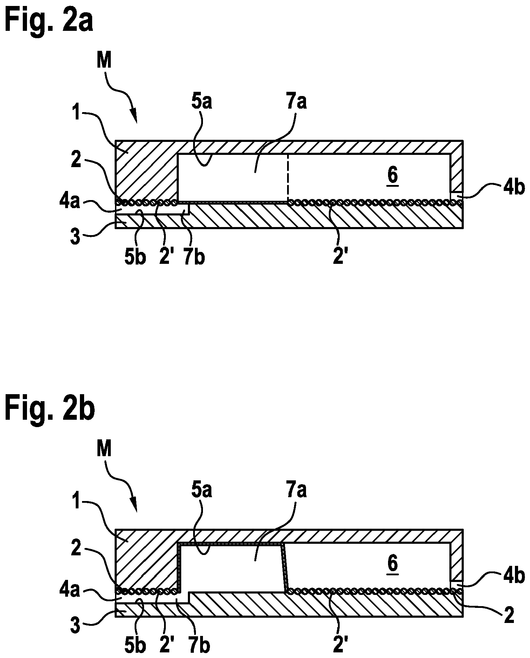

## Fig. 2a

## Fig. 2b

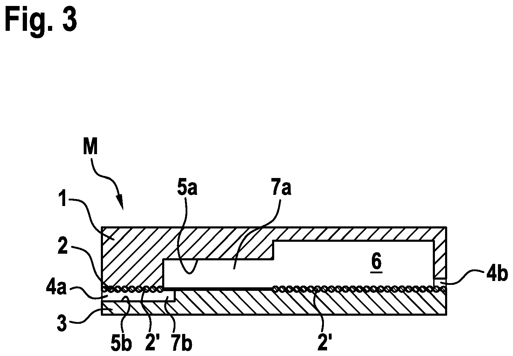

# Fig. 3

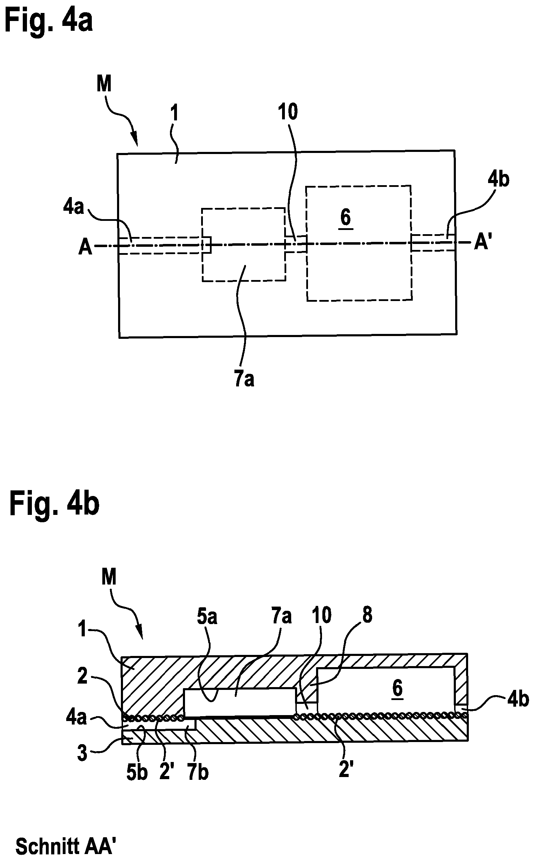

## Fig. 4a

## Fig. 4b

Schnitt AA'

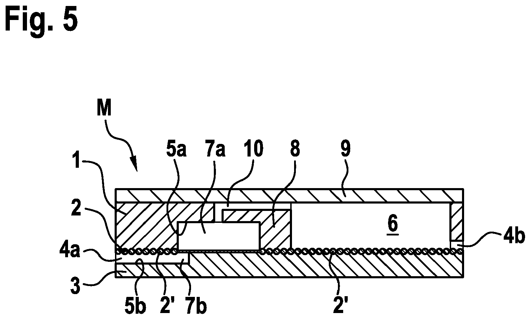

# Fig. 5

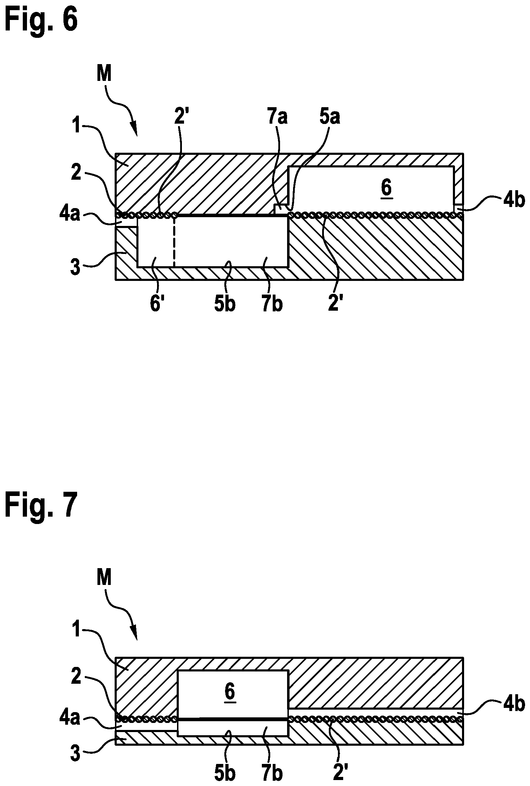

## Fig. 6

## Fig. 7

**IN DER BESCHREIBUNG AUFGEFÜHRTE DOKUMENTE**

**In der Beschreibung aufgeführte Patentdokumente**

- WO 2007109375 A2
- US 200770166199 A1
- WO 0241994 A2
- US 2010303687 A1
- US 2006076068 A1
- EP 2025405 A1